(19) **Europäisches Patentamt European Patent Office Office européen des brevets**

(11) **EP 4 249 929 B1**

(12) **EUROPEAN PATENT SPECIFICATION**

(45) Date of publication and mention of the grant of the patent:
**18.09.2024 Bulletin 2024/38**

(21) Application number: **22163134.4**

(22) Date of filing: **21.03.2022**

(51) International Patent Classification (IPC):
***G01R 31/367*** (2019.01)    ***G01R 31/374*** (2019.01)
***G01R 31/382*** (2019.01)

(52) Cooperative Patent Classification (CPC):
**G01R 31/367; G01R 31/374; G01R 31/382;**
**Y02E 60/10**

(54) **DETERMINATION OF OPEN CIRCUIT VOLTAGE CURVE FOR RECHARGEABLE BATTERIES**

BESTIMMUNG DER SPANNUNGSKURVE EINER OFFENEN SCHALTUNG FÜR WIEDERAUFLADBARE BATTERIEN

DÉTERMINATION D'UNE COURBE DE TENSION DE CIRCUIT OUVERT POUR BATTERIES RECHARGEABLES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**27.09.2023 Bulletin 2023/39**

(73) Proprietor: **TWAICE Technologies GmbH**
**80807 München (DE)**

(72) Inventors:
- **KIRST, Cedric**
  **80807 München (DE)**
- **KARGER, Alexander**
  **80807 München (DE)**
- **SINGER, Jan**
  **80807 München (DE)**

(74) Representative: **Kraus & Lederer PartGmbB**
**Thomas-Wimmer-Ring 15**
**80539 München (DE)**

(56) References cited:
**US-A1- 2013 317 771    US-A1- 2017 146 609**
**US-A1- 2017 363 690**

- **LAVIGNE L ET AL: "Lithium-ion Open Circuit Voltage (OCV) curve modelling and its ageing adjustment", JOURNAL OF POWER SOURCES, ELSEVIER, AMSTERDAM, NL, vol. 324, 6 June 2016 (2016-06-06), pages 694 - 703, XP029624652, ISSN: 0378-7753, DOI: 10.1016/J.JPOWSOUR.2016.05.121**

**Description**

TECHNICAL FIELD

According to examples of the disclosure, the dependency of the open circuit voltage on the state of charge of a battery, i.e., the OCV curve is determined, e.g., to facilitate determination of the state of health or state of charge of the battery. The OCV curve can be determined based on the values of multiple independent parameters, e.g., half-cell potentials (open-circuit potential) derived from degradation modes such as loss of lithium inventory or loss of active material at the cathode or anode.

BACKGROUND

The ageing state of a rechargeable battery, e.g., a lithium-ion battery, various models such as physical-chemical models, semi-empirical models or data-based models are known.

However, it has been observed that prior-art techniques of determining the aging state of rechargeable batteries are sometimes inaccurate. Prior art documents US2017/146609, US2013/317771, and US2017/363690 exemplify OCV curve estimation by direct measurement followed by corrections based on battery aging.

SUMMARY

Accordingly, a need exists for advanced techniques of estimating states of batteries. Specifically, a need exists for advanced techniques that facilitate accurate estimation of the aging state of rechargeable batteries.

This need is met by the features of independent claim 1.

The features of the dependent claims define embodiments.

According to the invention, a computer-implemented method includes obtaining at least one stress spectrum.

The at least one stress spectrum is indicative of a strength of multiple stress factors onto a battery during an observation duration. The computer-implemented method further includes determining values of multiple independent parameters of a predetermined parameterization associated with an open-circuit voltage curve of the battery. The values are determined based on the at least one stress spectrum. Further, the computer-implemented method includes determining the open-circuit voltage curve based on the values of the multiple independent parameters of the open-circuit voltage curve.

A computer program or a computer-program product or a computer-readable storage medium includes program code. The program code can be loaded and executed by at least one processor. Upon loading and executing the program code, the at least one processor performs a method. The method includes obtaining at least one stress spectrum. The at least one stress spectrum is indicative of a strength of multiple stress factors onto a battery during an observation duration. The computer-implemented method further includes determining values of multiple independent parameters of a predetermined parameterization associated with an open-circuit voltage curve of the battery. The values are determined based on the at least one stress spectrum. Further, the computer-implemented method includes determining the open-circuit voltage curve based on the values of the multiple independent parameters of the open-circuit voltage curve.

A device includes a processor and a memory. The processor can load program code from the memory and execute the program code. Upon loading and executing the program code, the at least one processor performs a method. The method includes obtaining at least one stress spectrum. The at least one stress spectrum is indicative of a strength of multiple stress factors onto a battery during an observation duration. The computer-implemented method further includes determining values of multiple independent parameters of a predetermined parameterization associated with an open-circuit voltage curve of the battery. The values are determined based on the at least one stress spectrum. Further, the computer-implemented method includes determining the open-circuit voltage curve based on the values of the multiple independent parameters of the open-circuit voltage curve.

It is to be understood that the features mentioned above and those yet to be explained below may be used not only in the respective combinations indicated, but also in other combinations or in isolation without departing from the scope of the invention. The scope is defined by the claims.

BRIEF DESCRIPTION OF THE DRAWINGS

FIG. 1 schematically illustrates a system according to various examples.
FIG. 2 schematically illustrates a battery according to various examples.
FIG. 3 schematically illustrates a server according to various examples.

FIG. 4 is a flowchart of a method according to various examples.
FIG. 5 is a flowchart of a method according to various examples.
FIG. 6 schematically illustrates a stress spectrum according to various examples.
FIG. 7 schematically illustrates anode and cathode open-circuit potentials (half-cell potentials) and an open-circuit voltage curve according to various examples.
FIG. 8 schematically illustrates an open circuit voltage curve according to various examples.

DETAILED DESCRIPTION

Some examples of the present disclosure generally provide for a plurality of circuits or other electrical devices. All references to the circuits and other electrical devices and the functionality provided by each are not intended to be limited to encompassing only what is illustrated and described herein. While particular labels may be assigned to the various circuits or other electrical devices disclosed, such labels are not intended to limit the scope of operation for the circuits and the other electrical devices. Such circuits and other electrical devices may be combined with each other and/or separated in any manner based on the particular type of electrical implementation that is desired. It is recognized that any circuit or other electrical device disclosed herein may include any number of microcontrollers, a graphics processor unit (GPU), integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, any one or more of the electrical devices may be configured to execute a program code that is embodied in a non-transitory computer readable medium programmed to perform any number of the functions as disclosed.

In the following, embodiments of the invention will be described in detail with reference to the accompanying drawings. It is to be understood that the following description of embodiments is not to be taken in a limiting sense. The scope of the invention is not intended to be limited by the embodiments described hereinafter or by the drawings, which are taken to be illustrative only.

The drawings are to be regarded as being schematic representations and elements illustrated in the drawings are not necessarily shown to scale. Rather, the various elements are represented such that their function and general purpose become apparent to a person skilled in the art. Any connection or coupling between functional blocks, devices, components, or other physical or functional units shown in the drawings or described herein may also be implemented by an indirect connection or coupling. A coupling between components may also be established over a wireless connection. Functional blocks may be implemented in hardware, firmware, software, or a combination thereof.

Various disclosed examples generally pertain to state estimation of one or more hidden states of a battery. For instance, state estimation can be applied to rechargeable batteries such as lithium-ion batteries.

According to various examples, it is possible to determine an open-circuit voltage curve (OCV), i.e., a dependency of the OCV on the state of charge (SOC). The OCV curve can be determined for a current aging state of the battery. The OCV is defined as the open-circuit potential difference between cathode and anode of the battery. A shape and/or amplitude of the OCV curve can be determined.

Based on the OCV curve, it may be possible to determine one or more estimates of states of the battery. For instance, it would be possible to determine the aging state of the battery, e.g., a state of health (SOH) of the battery. Typically, both the capacity, as well as the impedance of the battery will change as a function of age of the battery. Thus, to make a prediction of the available capacity, it is helpful to determine the SOH.

Various techniques disclosed herein are based on the finding that the OCV curve will change its shape as a function of progressive aging of the battery. Thus, by determining the OCV curve for the current aging state of the battery, based on the shape of the OCV curve, it is possible to make an estimate of the aging state of the battery.

Specifically, by estimating the aging state of the battery based on the OCV curve, it has been found that a more accurate estimate of the aging state if compared to prior art techniques as possible. The underlying reason is that the OCV curve serves as a unique fingerprint capturing all different kinds of degradation modes of the battery.

There are also techniques known that estimate the aging state of the battery based on the OCV curve. However, such prior art techniques sometimes do not accurately determine the OCV curve; and then, inaccuracies in the determination of the OCV curve translate into inaccuracies in the state estimation of the battery.

LIBs degrade gradually during use, leading to chemical and mechanical changes at the electrodes. These changes can happen due to a variety of concurrent chemical, mechanical, electrical, and thermal degradation mechanisms. Because the OCV of a lithium-ion battery is the potential difference between both electrodes, the changes at the electrodes manifest itself in changes in the OCV. The large number of degradation mechanisms are commonly categorized into a smaller number of degradation modes, depending on their effect on the changes in the OCV. A first example degradation mode would be loss of active material at an electrode of the battery. A second example degradation mode would be loss of mobile charge carrier inventory of the battery.

Various techniques are based on the finding that by determining the OCV curve, it is possible to capture the various independent degradation modes of the battery. More specifically, it is possible to capture the impact of the various degradation modes on the current aging state which manifests itself in the OCV curve.

In reference techniques, the OCV curve is typically measured at the beginning of life for a battery cell and this OCV curve is then stored and used in an electric-thermal model of the battery. The OCV curve, in reference techniques, can be measured with specific low-current or current-interruption methods; such measurements typically require a long time duration. Hence, in reference techniques changes of the OCV curve over lifetime are either neglected or partially updated in operation, since a full measurement of the OCV curve using such reference techniques is impractical during application. For a partial update of the OCV curve according to reference techniques, time series data of the voltage of the battery can be analyzed for relaxation points - i.e., where the battery has been at rest without charging or discharging for a significantly long time duration - and the OCV curve is then updated accordingly. See, e.g., Tong, S., Klein, M. P., & Park, J. W. (2015). On-line optimization of battery open circuit voltage for improved state-of-charge and state-of-health estimation. Journal of Power Sources, 293, 416-428. https://doi.org/10.1016/j.jpowsour.2015.03.157. Such reference techniques face certain restrictions. Specifically, it is required to identify relaxation points. It is not always possible to identify sufficient relaxation points. Sometimes, the data quality does not allow to identify relaxation points.

In the literature, it is sometimes suggested to update the OCV using a look-up table as a function of capacity. See Cheng, M. W., Lee, Y. S., Liu, M., & Sun, C. C. (2015). State-of-charge estimation with aging effect and correction for lithium-ion battery. IET Electrical Systems in Transportation, 5(2), 70-76. https://doi.org/10.1049/iet-est.2013.0007 , or Klintberg, A., Zou, C., Fridholm, B., & Wik, T. (2019). Kalman filter for adaptive learning of two-dimensional look-up tables applied to OCV curves for aged battery cells. Control Engineering Practice, 84, 230-237. https://doi.org/10.1016/j.conengprac.2018.11.023. For such look-up tables, a cell is empirically aged in the laboratory a priori. However, such techniques also face certain restrictions. Specifically, implementing a respective look-up table can be challenging, because the OCV-SOC curve needs to be stored in a parametrized manner depending on various changing conditions, e.g., temperature, aging state - e.g., SoH or capacity - , etc. Thus, the respective data structure of the lookup table can be large in size which is not always feasible for computationally efficient calculations. A further drawback of using a look-up table is that there is no unambiguous relationship between the aged OCV curve and state of health ,i.e., aging. Typically, a significant variation of the OCV curve for a given state of health is observed for batteries of an ensemble. Thus, using the look-up table inherently limits accuracy.

According to various examples, to avoid multi-dimensional look-up tables or restriction to specific relaxation points in the time series data of the voltage of the battery, as explained above in connection with the reference techniques, it is possible to use techniques as disclosed herein. The techniques disclosed herein facilitate a more accurate estimation of the OCV curve.

According to various examples, a parameterization of the OCV curve is relied upon. The parameterization includes multiple parameters. This means: Depending on the values that these parameters take, different OCV curves are obtained. The parameterization can specify the impact of various parameters onto the OCV curve. For instance, the shape and/or value of the OCV curve can vary as a function of the specific values that the parameters take.

During operation, it is possible to determine current values of multiple independent parameters associated with the OCV curve and based on these values of the multiple independent parameters, the OCV curve can be determined.

Thereby, during operation, the OCV curve can be determined depending on stress factors such as temperature, mean SOC, depth-of-discharge (DOD), time, charge and discharge C-rate.

More specifically, a two-step approach is possible. Firstly, it is possible to determine, based on one or more stress factors, parameters of the parameterization; then, secondly, based on the parameters of the parameterization the OCV curve can be determined. This is summarized in TAB. 1 below.

TAB. 1: Two-step approach for determining the OCV curve. The determination of the OCV curve can be assisted by machine-learning algorithms or other appropriately parameterized models that are employed in step I. By using such two-step approach, look-up tables are avoided.

| STEP | BRIEF DESCRIPTION | EXAMPLE DETAILS |
|---|---|---|
| I | Determine parameter values | One or more parameter values of the parameterization can be determined. There are various options available for implementing such determination of the one or more parameter values. |
| | | A predetermined model can be used. The predetermined model can be parameterized during training, i.e., based on training data obtained for a reference battery of the same battery type. |
| | | In particular, it would be possible to employ a machine-learning algorithm. The machine-learning algorithm can be trained to determine the one or more parameter values of the parameterization based on input data that is determined during operation of the battery. |
| | | For instance, the machine-learning algorithm could be implemented by an artificial neural network algorithm. |
| | | According to various examples, it is possible that such model for determining the parameter values operates based on at least one stress spectrum that is indicative of a strength of multiple stress factors onto the battery during operation in an observation duration. |
| | | For example, the respective data structure of the at least one stress spectrum can take the form of a 2-D array, wherein each array entry specifies the relative occurrence of operation of the battery at a respective operation point. |
| | | Such stress spectrum may not require including a temporal resolution of occurrence of specific stress factors onto the battery. In other words, such at least one stress spectrum can accumulate occurrences (without a particular time instance of occurrence) for multiple stress factors. |
| | | Each one of the at least one stress spectrum may be resolved with respect to two or more dimensions, different dimensions characterizing different operating points of the battery. For instance, example stress spectra may be resolved along one or more of the following dimensions: state of charge; depth of discharge; temperature; charging rate or discharging rate; exposure time; to give just a few examples. Such observables can be defined as averages across a certain stress interval. |
| | | For instance, one example stress spectrum could resolve charging rate vis-à-vis depth of discharge. Another example stress spectrum could resolve charging rate vis-à-vis temperature. Yet another charging spectrum could resolve state of charge of vis-à-vis exposure time. |
| II | Determine OCV curve | Based on the parameter values that are determined in step I, it is then possible to determine the OCV curve. This is based on the predetermined parameterization that translates the parameter values into shape and/or amplitude of the OCV curve. |

As a general rule, the parameterization can be with respect to various parameters.

In one example, the parameters can be mathematically defined. Thus, the multiple independent parameters can include orthogonal components of a functional decomposition of the OCV curve. Different basis functions for the parameterization can be chosen, so that the parameter values define the relative strength of contribution of the individual basis function as well as their position along SOC axis, e.g., the amplitude and/or position/localization (e.g., along SOC axis). I.e., the different contributions can be scaled and/or shifted. For instance, the OCV curve could be parametrized in accordance with a wavelet decomposition.

Alternatively or additionally to such mathematical definition of the parameters, e.g., in accordance with a respective decomposition of the OCV curve, it would be possible that a physical definition of the multiple independent parameters is used. In other words, the values that the multiple parameters take can have a physical meaning, going beyond a pure mathematical definition. To give an example, it would be possible that the multiple independent parameters parametrized multiple degradation modes of the battery. Degradation modes could be loss of active material at an electrode of the battery and/or loss of mobile charge carriers battery, e.g., loss of lithium inventory, to give a few examples. For example, it would be possible to rely on to orthogonal degradation modes, namely the cathode potential and the anode potential. Various degradation modes are disclosed in Birkl, Christoph R., et al. "Degradation diagnostics for lithium ion cells." Journal of Power Sources 341 (2017): 373-386.

Such techniques are based on the finding that it is possible to determine the impact of various operating profiles - captured by the at least one stress spectrum - specifically onto different degradation modes. For instance, a machine-learning algorithm can be used to determine the strength of individual degradation modes, i.e., respective parameter values of the parameterization, depending on the at least one stress spectrum, cf. TAB. 1: step I. By resolving the impact of the at least one stress spectrum onto the individual degradation modes, a more accurate determination of the OCV curve can be made.

Summarizing, a model-based two-step update of the OCV curve results in a reduced voltage and temperature error in any electrical thermal (ET) model, thus a more accurate calculation of simulated stress factors leading to an error reduction of the capacity prediction by any electrical thermal aging (ETA) model. Also, a reduced error for aged batteries for any state determination algorithm dependent on OCV data can be achieved. Multi-dimensional look-up tables can be avoided.

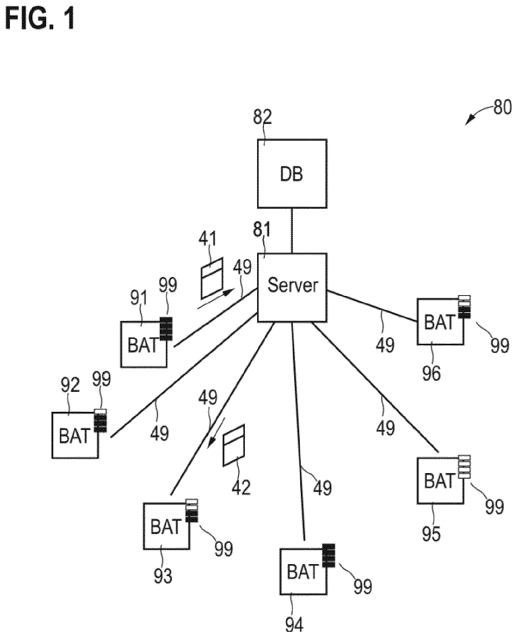

FIG. 1 illustrates aspects associated with a system 80. The system 80 comprises a server 81 which is connected to a database 82. In addition, the system 80 comprises communication connections 49 between the server 81 and each of several batteries 91-96. The communication connections 49 could be implemented, for example, via a cellular network.

In general, different battery types can be used in the various examples described herein. This means that the batteries 91-96 may comprise several types. Different types of batteries can be differentiated, for example, as relates to one or more of the following properties: shape of the cell (i.e., round cell, prismatic cell, etc.), cooling system (air cooling with active or passive design, coolant in coolant hose, passive cooling elements, etc.), the cell chemistry (e.g., electrode materials used, electrolytes, etc.), etc. There may also be a certain amount of variance between batteries 91-96 of the same type associated with such properties. For example, it is possible for batteries 91-96 of one and the same type to be mounted differently and thus different cooling systems are used. In addition, the same battery cells may sometimes be arranged differently such that there is variance in an electrical and thermal system analysis of the collection of cells.

As a general rule, such battery-specific and/or type-specific effects can be considered in association with different parameterizations of an OCV curve. For instance, different parameterizations may be determined for different types of batteries.

FIG. 1 illustrates by way of example that the batteries 91-96 can transmit state data 41 to the server 81 via the communication connections 49. For example, it would be possible for the state data 41 to be indicative of one or more operating values of the respective battery 91-96, i.e., it is possible to index measured data. The state data 41 can be transmitted in an event-driven manner or according to a predefined timetable.

These state data 41 can be used in connection with determining an OCV curve for the various batteries 91-96. For instance, it would be possible that based on these state data 41, at least one stress spectrum is determined at the server 81. Then, based on the at least one stress spectrum, the server 81 can determine values of multiple independent parameters that are associated with the OCV curve. In other examples, the state data 41 could already include or consist of the at least one stress spectrum; i.e., the at least one stress spectrum can be determined locally at the batteries 91-96. Thereby, reduced signaling bandwidth is required on the communication connections 49, because typically the stress spectra can be devoid of temporal resolution, thus resulting in a smaller size of the associated data structure if compared to, e.g., time series data.

FIG. 1 also illustrates by way of example that the server 81 can transmit control data 42 to the batteries 91-96 via the communication connections 49. For example, it would be possible for the control data 42 to index one or more operating limits for the future operation of the respective battery 91-96. For example, the control data could index one or more control parameters for thermal management of the respective battery 91-96 and/or charge management of the respective battery 91-96. The server 81 can thus influence or control the operation of the batteries 91-96 through the use of the control data 42. For instance, the server 81 may determine the control data based on a current OCV curve that is determined for the respective battery 91-96. More specifically, the server 81 may determine the control data 42 based on a state estimate of the battery that is determined based on the OCV curve. For instance, the control data 42 could be determined based on an SOH that is determined based on the OCV curve.

FIG. 1 additionally illustrates schematically the respective SOH 99 for each of the batteries 91-96. As a general rule, the SOH 99 of a battery 91-96 may comprise one or more different variables depending on implementation. Typical variables of the SOH 99 may be, for example: electrical capacity, i.e., the maximum possible stored charge; and/or electrical impedance, i.e., the frequency response of the resistance or alternating current resistance as a ratio between the electrical voltage and electrical current strength.

Techniques for state estimation are described in the following, which make it possible to determine the SOH 99 and/or other characteristic variables for the state of the batteries 91-96 for each of the batteries 91-96 during use of the batteries 91-96. This means that, for example, the electrical impedance and/or the electrical capacity can be determined. This can take place on the server by means of a predetermined parameterization of an OCV curve. The server 81 could then provide corresponding information regarding the SOH 99 to the batteries 91-96, for example via the control data 42. A management system of the batteries 91-96 could then adapt an operating profile for the batteries in order to prevent, for example, further degradation of the SOH 99.

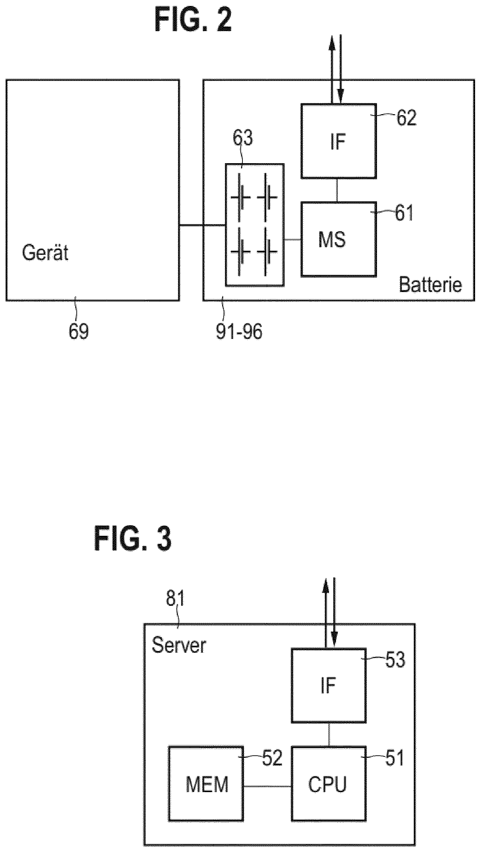

FIG. 2 illustrates aspects associated with the batteries 91-96. The batteries 91-96 are coupled to a respective device 69. This device is driven by electrical energy from the respective battery 91-96.

The batteries 91-96 comprise or are associated with one or more management systems 61, e.g., a BMS or a different control logic such as an on-board unit in the case of a vehicle. The management system 61 can be implemented, for example, by software on a CPU. Alternatively, or additionally, an application-specific integrated circuit (ASIC) or a field-programmable gate array (FPGA) can be used, for example. The batteries 91-96 can communicate with the management system 61 via a bus system, for example. The batteries 91-96 also comprise a communication interface 62. The management system 61 can establish a communication connection 49 with the server 81 via the communication interface 62.

While the management system 61 is designated separately from the batteries 91-96 in FIG. 2, it is also possible in other examples for the management system 61 to be part of the batteries 91-96.

In addition, the batteries 91-96 comprise one or more battery blocks 63. Each battery block 63 typically comprises several battery cells connected in parallel and/or in series. Electrical energy can be stored there.

Typically, the management system 61 can rely on one or more sensors in the one or more battery blocks 63. The sensors can measure, for example, the current flow and/or the voltage in at least some of the battery cells. Alternatively, or additionally, the sensors can also measure other variables in association with at least some of the battery cells to determine, for example, temperature, volume, pressure, etc. of the battery and to transmit this information to the server 81 in the form of state data 41. The management system 61 can also be configured to implement thermal management and/or charge management of the respective battery 91-96. In association with the thermal management, the management system 61 can control, for example, cooling and/or heating. In association with the charge management, the management system 61 can control, for example, a rate of charge or a depth of discharges. Thus, the management system 61 can set one or more boundary operating conditions for operation of the respective battery 91-96, for example, based on the control data 42.

FIG. 3 illustrates aspects associated with the server 81. The server 81 comprises a processor 51 and a memory 52. The memory 52 may comprise a volatile memory element and/or a nonvolatile memory element. In addition, the server 81 also comprises a communication interface 53. The processor 51 can establish a communication connection 49 with each of the batteries 91-96 and the database 82 via the communication interface 53.

For example, program code may be stored in the memory 52 and loaded by the processor 51. The processor 51 can then execute the program code. The execution of the program code causes the processor 51 to execute one or more of the following processes, as they are described in detail herein in association with the various examples: characterizing batteries 91-96; carrying out one or more state predictions for one or more of the batteries 91-96, for example based on operating values such as at least one stress spectrum which are received from the corresponding batteries 91-96 as state data 41 via the communication connection; determining an OCV curve of batteries 91-96; implementing an aging estimate of batteries based on one or more operating profiles and a determined OCV curve; transmitting control data 42 to batteries 91-96, for example, in order to set boundary operating conditions; storing an event of state monitoring of a corresponding battery 91-96 in a database 82; etc.

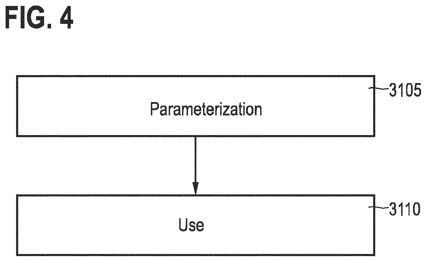

FIG. 4 schematically illustrates a method according to various examples. FIG. 4 schematically illustrates aspects with respect to setting up one or more models that facilitate determining an OCV curve according to various examples.

Initially, at box 3105, it is possible to determine a parameterization that includes multiple parameters that impact an OCV curve. In other words, the parameterization breaks down an OCV curve into constituting basis functions, as well as employing such parameterization for determining the OCV curve during use.

Determining the parameterization (or at least a part thereof) can be implemented in a laboratory measurement.

As part of the laboratory measurements, it would be possible to use fast C/10 or even higher constant current checkups which are used to estimate the OCV curve degradation, e.g., with a half-cell optimization algorithm. See Birkl, Christoph R., et al. "Degradation diagnostics for lithium ion cells." Journal of Power Sources 341 (2017): 373-386.

For instance, it would be possible to take existing aging data of the battery cells of the battery and combine this with laboratory measurement of specific check-up cycles. Such check-up cycles can impose a certain predetermined low profile onto the charging and/or discharging of the battery. It is then possible to reveal the OCV curve and correlate the OCV curve with one or more battery states, e.g., the state of health.

Alternatively or additionally to such determining of the parameterization, as part of box 3105, it would be possible to set-up a model that is used to convert at least one stress spectrum into values of multiple parameters of the parameterization. For instance, it would also be possible to train an ML algorithm to determine parameter values of the parameterization of the OCV curve based on at least one stress spectrum. The particular implementation of such training can depend on the choice of parameterization. To give a first example, it would be possible that the multiple independent parameters of the parameterization parameterize multiple degradation modes of the battery. Here, it would be possible to use training data that links - e.g., empirically measured - stress spectra to the multiple degradation modes, as ground truth. For instance, ground truth labels specifying the degradation modes as a function of stress spectra could be obtained from measurements or could be obtained from simulations or could be obtained from literature. To give a second example, it would be possible that the multiple independent parameters include orthogonal components of a functional decomposition of the OCV curve. Here, it would be possible to obtain respective ground truth as a relationship between stress spectra and changes to the OCV curve; along with this, it would be possible to break-down these changes to the OCV curve for each one of the orthogonal components of the functional decomposition by mathematical operations.

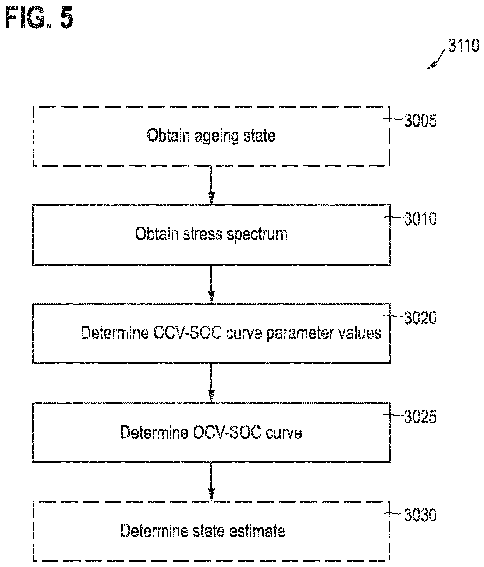

Next, at box 3110, inference can take place. Here, ground truth is not required. Box 3110 builds on box 3105. It is possible to monitor operation of a battery during an observation duration and determine at least one stress spectrum during the observation duration. This at least one stress spectrum can then serve as an input to an appropriate algorithm, e.g., a machine-learning algorithm, that determines values of multiple independent parameters of a predetermined parameterization based thereon. Then, using the predetermined parameterization, it is possible to determine the OCV curve based on these values. It would optionally be possible to estimate the state of the battery based on the OCV curve, e.g., determine an estimate of the state of health. Details with respect to box 3110 are explained in connection with FIG. 5.

FIG. 5 is a flowchart of a method according to various examples. FIG. 5 schematically illustrates aspects with respect to a method facilitating a state estimation of the state of the battery. For example, the method of FIG. 5 could be executed by a device including a processor that can load and execute program code. For example, the method of FIG. 5 could be executed by the server 81, more specifically, by the processor 51 upon loading and executing program code from the memory 52.

The method of FIG. 5 pertains to inference. As such, the method of FIG. 5 can implement box 3110 of the method of FIG. 4. The method of FIG. 5 uses a pre-trained model that can determine one or more parameter values of parameters of a parameterization of an OCV curve based on at least one stress spectrum. Also, the parameterization is predetermined such that once the one or more parameter values have been determined it is possible to determine the OCV curve.

Optional boxes are labeled with dashed lines in FIG. 5.

Initially, at box 3005, it is possible to obtain an aging state of the battery. For instance, the SOH of the battery can be obtained. For instance, a previous estimate of the aging state can be obtained. More specifically, it is possible to obtain at least one indicator that is indicative of an aging state of the battery associated with an observation duration.

For instance, such at least one indicator could be loaded from a memory. Such at least one indicator could be obtained from a previous iteration of the method, e.g., where previously the state of health has been determined based on the OCV curve.

The at least one indicator that can thus be indicative of the aging state at a beginning of prior to the observation duration.

Such techniques are based on the finding that it can sometimes be helpful to have a reference baseline for determining parameter values of the parameterization of the OCV curve based on at least one stress spectrum; this is because the impact of certain stress factors onto the OCV curve can itself vary over the course of aging of the battery. For instance, a deep discharge of the battery can have a less severe impact on to the shape of the OCV curve and/or the amplitude of the OCV curve for a relatively young battery if compared to the impact of the same deep discharge onto an aged battery.

Next, at box 3010, it is possible to obtain at least one stress spectrum.

For instance, the at least one stress spectrum may be obtained from a battery management system of the battery. State data could be received that is indicative of the at least one stress spectrum (cf. FIG. 1: state data 41).

It would be possible that box 3010 includes determining the at least one stress spectrum based on time series data of, e.g., terminal voltage, current, temperature, and/or other observables of the operation of the battery.

To give an example, it would be possible to obtain time series data of a terminal voltage of the battery, as well as a current of the battery. Then, it would be possible to identify multiple stress intervals in the time series data. The stress interval can be associated with exposure of the battery to a given stress factor of the multiple stress factors. It would then be possible to determine the at least one stress spectrum based on at least one of an incidence or a duration of the stress intervals for each one of the multiple stress factors. Thus, it would be possible to count the frequency of occurrence of certain stress factors. Alternatively or additionally, it would be possible to determine the length of exposure of the battery to a given stress factor.

As a general rule, it would be possible to consider cyclic ageing as well as calendrical ageing, by appropriately configuring the stress intervals.

As a further general rule, there would be various stress factors and, accordingly, various fingerprints of stress intervals conceivable. One example stress interval could be characterized by a significant change of the terminal voltage over time and a large level of the battery current for an extended duration, i.e., beyond respective thresholds. This would pertain to a fast discharging of the battery. It would be, in particular, be possible to detect such fast discharging of the battery, e.g., occurrence of fast discharging, duration or depth-of-discharge of the fast discharging. Such an approach is fundamentally different to the prior art techniques that attempt to update the OCV curve by obtaining measurements for the OCV during the relaxation of the battery, i.e., at operating states where the battery has not been charged or discharged for a certain time duration.

It would be possible that the at least one stress spectrum is indicative of one or stress factors as observed during an observation duration. The observation duration could correspond to a predetermined time duration during which the battery has been operated. For instance, the observation period could be defined with respect to a previous update of the OCV curve, i.e., the time period that has lapsed since a previous execution of box 3010.

Alternatively or additionally, it would also be possible to make a prediction of the at least one stress spectrum at box 3010, i.e., for a future point in time. Here, it would be possible to obtain at least one further stress spectrum that is indicative of the strength of the multiple stress factors during a further observation duration and then predict the at least one stress spectrum at box 3010. In other words, based on the strength of stress factors, as observed during operation of the battery, it can be possible to make a prediction of the at least one stress spectrum; thereby, it is possible to make predictions of the OCV curve for a future point in time. Such prediction of the at least one stress spectrum can be seen as an augmentation of the at least one stress spectrum so that future operation is covered as well.

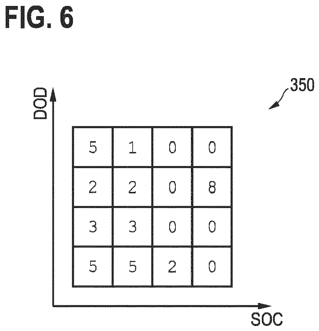

An example stress spectrum 350 is illustrated in FIG. 6. FIG. 6 illustrates a two dimensional (2-D) stress spectrum 350, indicating the frequency of occurrence of operating the battery at certain depth of discharge charging operations, as well as respective mean SOC values. This is only one example. It would be possible to rely on higher-dimensional stress spectra, e.g., 3-D or 4-D stress spectra. It would be possible to rely on stress spectra that are resolved with respect to different operating dimensions, e.g., temperature, charging rate, to give just a few examples.

Next, at box 3020, it is possible to determine one or more parameter values of a predetermined parameterization of the OCV curve. This determination at box 3020 depends on the at least one stress spectrum that is obtained at box 3010, as well as - where applicable - the aging state of the battery is obtained at box 3005. For instance, respective input channels of a neural network algorithm can receive each one of the at least one stress spectrum, and optionally the ageing state.

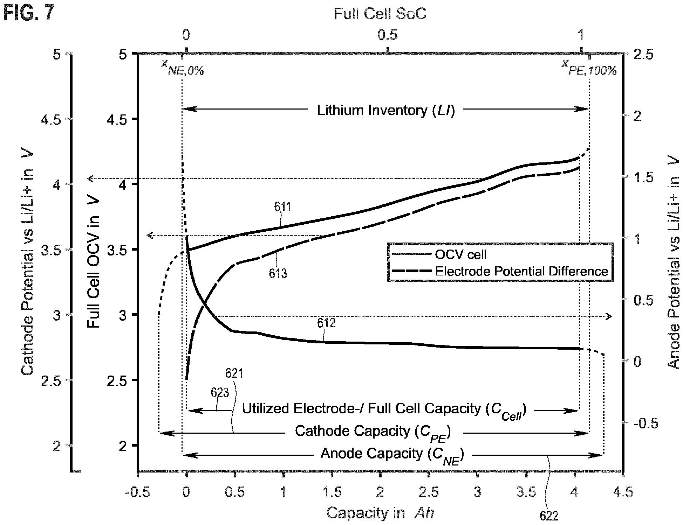

It is then possible, at box 3025, to determine the OCV curve based on the one or more parameter values that have been determined at box 3020, taking into account the predetermined parameterization. The multiple independent parameters can define a shape and an amplitude of the OCV curve of the battery. An example parameterization is illustrated in FIG. 7.

FIG. 7 illustrates two parameters impacting the OCV curve, namely, the open-circuit potential (OCP) for the positive electrode and the negative electrode, respectively. Degradation of lithium-ion batteries, which can be quantified by the degradation modes, leads to changes in the negative and positive electrode OCPs.

FIG. 7 illustrates the cathode OCP 611 (left scale) and the anode OCP 612 (right scale), varying across the cathode capacity 621 and the anode capacity 622.

Only a fraction of the full capacity is utilized for charging and discharging the battery cell, as illustrated by the utilized full cell capacity 623; within that utilized full cell capacity 623, the OCP difference gives the OCV curve 613 (dashed line).

One degradation mode pertains to the loss of active material (LAM) at the negative electrode (anode) - see Eq. 1 - and the positive electrode (cathode) - see Eq. 2,

$$LAM_{NE} = 1 - \frac{c_{NE,i}}{c_{NE,0}}, \qquad\qquad (1)$$

$$LAM_{PE} = 1 - \frac{c_{PE,i}}{c_{PE,0}}, \qquad\qquad (2)$$

where i indices the aged state, $c_{NE,0}$ and $c_{PE,0}$ are capacities of the negative electrode and the positive electrode in the non-aged state, respectively, and $c_{NE,i}$ and $c_{PE,i}$ are the capacities of the negative electrode and the positive electrode in the aged state, respectively.

Accordingly, a loss of active material at the anode would result in a horizontal compression of the curve 612 (cf. FIG. 7; Eq. 1); a loss of active material at the cathode would result in a horizontal compression of the curve 611 (cf. FIG. 7; Eq. 2).

Another degradation mode pertains to loss of lithium inventory (LLI). This is described by Eq. 3:

$$LLI = 1 - \frac{LI_i}{LI_0} = 1 - \frac{(x_{PE,100\%,i} - x_{NE,0\%,i})C_{Cell,i}}{(x_{PE,100\%,0} - x_{NE,0\%,0})C_{Cell,0}} \qquad (3)$$

$LI_i$ describes the amount of lithium inventory in the aged state; and $LI_0$ describes the amount of lithium inventory in the non-aged state. Hence, a loss of lithium inventory would result in a relative horizontal shift of the curve 611 with respect to the curve 612 (cf. Eq. 3; FIG. 7).

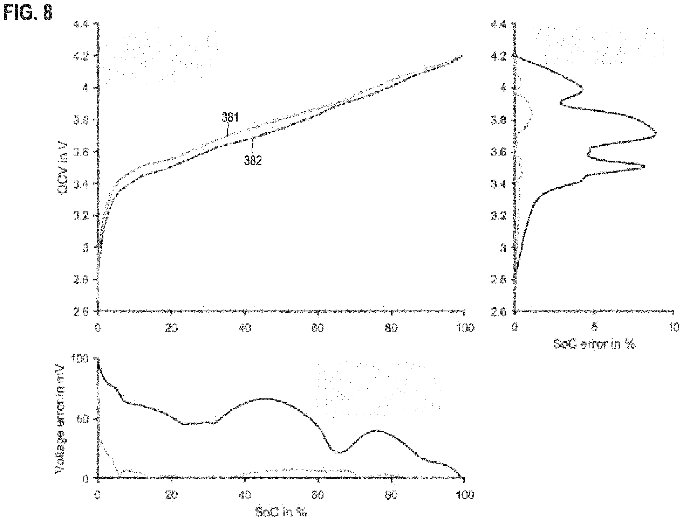

As will be appreciated from the above, the degradation modes according to Eqs. 1-3, thus specify impacts on the anode and cathode OCP which, in turn, translate into the OCV curve; thus, the degradation modes are parameters of a respective predetermined parameterization of the OCV curve. The specific values of the LAM or LLI thus specify rules for changes of the anode and cathode OCP to thereby yield the OCV curve, i.e., the horizontal compression and/or horizontal shift, as explained above. FIG. 8 illustrates the resulting OCV curve 381 obtained from such techniques. For instance, OCV curve 381 could correspond to the OCV curve 613. Illustrated is the OCV curve 381 that is determined based on the open circuit potentials as degradation modes for the negative and positive electrodes, as discussed above in connection with FIG. 7. Also illustrated is a reference OCV curve 382, that has been calculated according to reference techniques. It is apparent that the OCV curve 381 deviates in both shape and amplitude from the reference OCV curve 382. This translates into errors in the SOC estimation (FIG. 8: right side), as well as errors in the estimation of the open circuit voltage based on SOC (FIG. 8: bottom part).

Referring again to FIG. 5: optionally, at box 3030, it is possible to determine a state estimate of at least one state of the battery, based on the OCV curve that has been determined at box 3025.

Although the invention has been shown and described with respect to certain preferred embodiments, modifications will occur to others skilled in the art upon the reading and understanding of the specification. The present invention includes all such modifications and is limited only by the scope of the appended claims.

**Claims**

1. A computer-implemented method, comprising:

   - obtaining at least one stress spectrum (350) indicative of a strength of multiple stress factors onto a battery (91) during an observation duration,
   - based on the at least one stress spectrum, determining values of multiple independent parameters (611, 612) of a predetermined parameterization associated with an open-circuit voltage curve (613, 381) of the battery, and
   - determining the open-circuit voltage curve (613, 381) based on the values of the multiple independent parameters of the open-circuit voltage curve

2. The computer-implemented method of claim 1,
   wherein the multiple independent parameters of the parameterization para-metrize multiple degradation modes of the battery.

3. The computer-implemented method of claim 1 or 2,
   wherein the multiple independent parameters comprise a first indicator indicative of loss of active material at an electrode of the battery at an end of the observation duration and a second indicator indicative of loss of a mobile charge carrier inventory of the battery at an end of the observation duration.

4. The computer-implemented method of claim 1,
   wherein the multiple independent parameters of the parameterization comprise orthogonal components of a functional decomposition of the open voltage curve.

5. The computer-implemented method of any one of the preceding claims,
   wherein the at least one stress spectrum comprises at least one multi-dimensional stress spectrum, wherein one or more dimensions of the at least one multi-dimensional stress spectrum are selected from the group comprising: average temperature during a respective stress interval; average charging or discharging rate during a respective stress interval; depth-of-discharge of a respective stress interval; and average state-of-charge of a respective stress interval.

6. The computer-implemented method of any one of the preceding claims,
   wherein the multiple stress factors are associated with both cyclic ageing as well as calendrical ageing of the battery.

7. The computer-implemented method of any one of the preceding claims, further comprising:

   - obtaining time series data of a terminal voltage of the battery and a current of the battery,
   - identifying multiple stress intervals in the time series data, each stress interval being associated with exposure of the battery to a respective stress factor of the multiple stress factors, and
   - determining the at least one stress spectrum based on at least one of an incidence or a duration of the stress intervals for each one of the multiple stress factors.

8. The computer-implemented method of any one of the preceding claims, further comprising:

   - obtaining time series data of a terminal voltage of the battery and a current of the battery,
   - identifying, in the time series data, one or more stress intervals associated with fast discharging of the battery, and
   - determining the at least one stress spectrum based on at least one of an incidence or a duration of the one or more stress intervals associated with the fast discharging of the battery.

9. The computer-implemented method of any one of the preceding claims, further comprising:

   - obtaining at least one further stress spectrum indicative of the strength of the multiple stress factors onto the battery during a further observation duration, and
   - predicting the at least one stress spectrum based on the at least one further stress spectrum and a predetermined usage pattern of the battery during the observation duration.

10. The computer-implemented method of any one of the preceding claims, further comprising:

    - obtaining at least one indicator indicative of an ageing state of the battery associated with the observation duration,

    wherein the multiple independent parameters are further determined based on the at least one indicator indicative of the ageing state of the battery.

11. The computer-implemented method of claim 10,
    wherein the at least one indicator indicative of the ageing state comprises a first indicator indicative of a loss of active material at an electrode of the battery at a beginning of the observation duration and a second indicator indicative of loss of a mobile charge carrier inventory of the battery at a beginning of the observation duration.

12. The computer-implemented method of any one of the preceding claims,
    wherein the multiple independent parameters define a shape and an amplitude of the open circuit voltage curve of the battery.

13. The computer-implemented method of any one of the preceding claims,
    wherein the multiple independent parameters are determined based on the at least one stress spectrum using a predetermined model, the predetermined model being parameterized based on training data obtained for a reference battery of the same battery type of the battery.

14. The computer-implemented method of any one of the preceding claims, further comprising:

    - determining the estimate of the state of the battery based on the open-circuit voltage curve.

15. The computer-implemented method of any one of the preceding claims, further comprising:

    - in a laboratory measurement, determining at least one of at least a part of the parameterization of the open-circuit voltage curve of the battery with respect to the multiple independent parameters or a model for determining the values of the multiple independent parameters based on the at least one stress spectrum.

## Patentansprüche

1. Computerimplementiertes Verfahren, das Folgendes umfasst:

   - Erhalten mindestens eines Belastungsspektrums (350), das eine Stärke mehrerer Belastungsfaktoren auf eine Batterie (91) während einer Beobachtungsdauer anzeigt,
   - Bestimmen von Werten mehrerer unabhängiger Parameter (611, 612) einer vorbestimmten Parametrisierung, die mit einer Leerlaufspannungskurve (613, 381) der Batterie assoziiert sind, basierend auf dem mindestens einen Belastungsspektrum, und
   - Bestimmen der Leerlaufspannungskurve (613, 381) auf der Grundlage der Werte der mehreren unabhängigen Parameter der Leerlaufspannungskurve.

2. Computerimplementiertes Verfahren nach Anspruch 1, wobei die mehreren unabhängigen Parameter der Parametrisierung mehrere Degradationsmodi der Batterie parametrisieren.

3. Computerimplementiertes Verfahren nach Anspruch 1 oder 2, wobei die mehreren unabhängigen Parameter einen ersten Indikator, der den Verlust von aktivem Material an einer Elektrode der Batterie am Ende der Beobachtungsdauer anzeigt, und einen zweiten Indikator, der den Verlust eines mobilen Ladungsträgerbestands der Batterie am Ende der Beobachtungsdauer anzeigt, umfassen.

4. Computerimplementiertes Verfahren nach Anspruch 1, wobei die mehreren unabhängigen Parameter der Parametrisierung orthogonale Komponenten einer funktionalen Zerlegung der Leerlaufspannungskurve umfassen.

5. Computerimplementiertes Verfahren nach einem der vorhergehenden Ansprüche, wobei das mindestens eine Belastungsspektrum mindestens ein mehrdimensionales Belastungsspektrum umfasst, wobei eine oder mehrere Dimensionen des mindestens einen mehrdimensionalen Belastungsspektrums aus der Gruppe ausgewählt sind, die Folgendes umfasst:

   durchschnittliche Temperatur während eines bestimmten Belastungsintervalls;
   durchschnittliche Lade- oder Entladerate während eines bestimmten Belastungsintervalls;
   Entladungstiefe eines jeweiligen Belastungsintervalls; und
   durchschnittlicher Ladungszustand eines jeweiligen Belastungsintervalls.

6. Computerimplementiertes Verfahren nach einem der vorhergehenden Ansprüche, wobei die mehrfachen Belastungsfaktoren sowohl mit der zyklischen als auch mit der kalendarischen Alterung der Batterie verbunden sind.

7. Computerimplementiertes Verfahren nach einem der vorangegangenen Ansprüche, das ferner Folgendes umfasst:

   - Erhalten von Zeitreihendaten einer Klemmenspannung der Batterie und eines Stroms der Batterie,
   - Identifizieren mehrerer Belastungsintervalle in den Zeitreihendaten, wobei jedes Belastungsintervall mit der Exposition der Batterie gegenüber einem entsprechenden Belastungsfaktor der mehreren Belastungsfaktoren verbunden ist, und
   - Bestimmen des mindestens einen Belastungsspektrums auf der Grundlage von mindestens einer Häufigkeit oder einer Dauer der Belastungsintervalle für jeden einzelnen der mehreren Belastungsfaktoren.

8. Computerimplementiertes Verfahren nach einem der vorangegangenen Ansprüche, das ferner Folgendes umfasst:

   - Erhalten von Zeitreihendaten einer Klemmenspannung der Batterie und eines Stroms der Batterie,
   - Identifizieren eines oder mehrerer Belastungsintervalle in den Zeitreihendaten, die mit einer schnellen Entladung der Batterie verbunden sind,
   und
   - Bestimmen des mindestens einen Belastungsspektrums auf der Grundlage der Häufigkeit und/oder der Dauer des einen oder der mehreren Belastungsintervalle, die mit dem schnellen Entladen der Batterie verbunden sind.

9. Computerimplementiertes Verfahren nach einem der vorangegangenen Ansprüche, das ferner Folgendes umfasst:

- Erhalten mindestens eines weiteren Belastungsspektrums, das die Stärke der mehrfachen Belastungsfaktoren auf die Batterie während einer weiteren Beobachtungsdauer angibt, und
- Vorhersagen des mindestens einen Belastungsspektrums auf der Grundlage des mindestens einen weiteren Belastungsspektrums und eines vorgegebenen Nutzungsmusters der Batterie während der Beobachtungsdauer.

10. Computerimplementiertes Verfahren nach einem der vorangegangenen Ansprüche, das ferner Folgendes umfasst:

- Erhalten von mindestens einem Indikator, der einen Alterungszustand der Batterie in Verbindung mit der Beobachtungsdauer anzeigt,

wobei die mehreren unabhängigen Parameter ferner auf der Grundlage des mindestens einen Indikators bestimmt werden, der den Alterungszustand der Batterie anzeigt.

11. Computerimplementiertes Verfahren nach Anspruch 10,
wobei der mindestens eine Indikator, der den Alterungszustand anzeigt, einen ersten Indikator, der einen Verlust von aktivem Material an einer Elektrode der Batterie zu Beginn der Beobachtungsdauer anzeigt, und einen zweiten Indikator, der einen Verlust eines mobilen Ladungsträgerbestands der Batterie zu Beginn der Beobachtungsdauer anzeigt, umfasst.

12. Computerimplementiertes Verfahren nach einem der vorhergehenden Ansprüche,
wobei die mehreren unabhängigen Parameter eine Form und eine Amplitude der Leerlaufspannungskurve der Batterie definieren.

13. Computerimplementiertes Verfahren nach einem der vorhergehenden Ansprüche,
wobei die mehreren unabhängigen Parameter auf der Grundlage des mindestens einen Belastungsspektrums unter Verwendung eines vorbestimmten Modells bestimmt werden, wobei das vorbestimmte Modell auf der Grundlage von Trainingsdaten parametrisiert wird, die für eine Referenzbatterie desselben Batterietyps der Batterie erhalten wurden.

14. Computerimplementiertes Verfahren nach einem der vorangegangenen Ansprüche, das ferner Folgendes umfasst:

- Bestimmen der Schätzung des Batteriezustands auf der Grundlage der Leerlaufspannungskurve.

15. Computerimplementiertes Verfahren nach einem der vorangegangenen Ansprüche, das ferner Folgendes umfasst:

- in einer Labormessung, Bestimmen zumindest eines Teils der Parametrisierung des Leerlaufspannungsverlaufs der Batterie in Bezug auf die mehreren unabhängigen Parameter oder ein Modell zur Bestimmung der Werte der mehreren unabhängigen Parameter auf der Grundlage des mindestens einen Belastungsspektrums.

**Revendications**

1. Procédé mis en œuvre par ordinateur, comprenant :

- l'obtention d'au moins un spectre de contraintes (350) indicatif d'une intensité de multiples facteurs de contraintes sur une batterie (91) au cours d'une durée d'observation,
- en fonction de l'au moins un spectre de contraintes, la détermination de valeurs de multiples paramètres indépendants (611, 612) d'une paramétrisation prédéterminée associée à une courbe de tension de circuit ouvert (613, 381) de la batterie, et
- la détermination de la courbe de tension de circuit ouvert (613, 381) en fonction des valeurs des multiples paramètres indépendants de la courbe de tension de circuit ouvert.

2. Procédé mis en œuvre par ordinateur selon la revendication 1,
dans lequel les multiples paramètres indépendants de la paramétrisation paramétrisent de multiples modes de dégradation de la batterie.

3. Procédé mis en œuvre par ordinateur selon la revendication 1 ou 2,

dans lequel les multiples paramètres indépendants comprennent un premier indicateur indiquant une perte de matière active au niveau d'une électrode de la batterie à une fin de la durée d'observation et un second indicateur indiquant une perte d'un stock de porteurs de charge mobile de la batterie à une fin de la durée d'observation.

4. Procédé mis en œuvre par ordinateur selon la revendication 1,
dans lequel les multiples paramètres indépendants de la paramétrisation comprennent des composantes orthogonales d'une décomposition fonctionnelle de la courbe de tension ouverte.

5. Procédé mis en œuvre par ordinateur selon l'une quelconque des revendications précédentes,
dans lequel l'au moins un spectre de contraintes comprend au moins un spectre de contraintes multidimensionnel, dans lequel une ou plusieurs dimensions de l'au moins un spectre de contraintes multidimensionnel sont sélectionnées dans le groupe comprenant : température moyenne durant un intervalle de contraintes respectif ; taux moyen de charge ou de décharge durant un intervalle de contrainte respectif ; profondeur de décharge d'un intervalle de contrainte respectif ; et état de charge moyen d'un intervalle de contrainte respectif.

6. Procédé mis en œuvre par ordinateur selon l'une quelconque des revendications précédentes, dans lequel les multiples facteurs de contraintes sont associés à la fois à un vieillissement cyclique et à un vieillissement calendaire de la batterie.

7. Procédé mis en œuvre par ordinateur selon l'une quelconque des revendications précédentes, comprenant en outre :

- l'obtention de données de séries chronologiques d'une tension de borne de la batterie et d'un courant de la batterie,
- l'identification de multiples intervalles de contraintes dans les données de séries chronologiques, chaque intervalle de contrainte étant associé à l'exposition de la batterie à un facteur de contrainte respectif des multiples facteurs de contraintes, et
- la détermination de l'au moins un spectre de contraintes en fonction d'au moins une d'une incidence ou d'une durée des intervalles de contraintes pour chacun des multiples facteurs de contraintes.

8. Procédé mis en œuvre par ordinateur selon l'une quelconque des revendications précédentes, comprenant en outre :

- l'obtention de données de séries chronologiques d'une tension de borne de la batterie et d'un courant de la batterie,
- l'identification, dans les données de séries chronologiques, d'un ou plusieurs intervalles de contraintes associés à une décharge rapide de la batterie, et
- la détermination de l'au moins un spectre de contraintes en fonction d'au moins une d'une incidence ou d'une durée des un ou plusieurs intervalles de contraintes associés à la décharge rapide de la batterie.

9. Procédé mis en œuvre par ordinateur selon l'une quelconque des revendications précédentes, comprenant en outre :

- l'obtention d'au moins un autre spectre de contraintes indicatif de l'intensité des multiples facteurs de contraintes sur la batterie au cours d'une durée d'observation supplémentaire, et
- la prédiction de l'au moins un spectre de contraintes en fonction de l'au moins un autre spectre de contraintes et d'un modèle d'utilisation prédéterminé de la batterie au cours de la durée d'observation.

10. Procédé mis en œuvre par ordinateur selon l'une quelconque des revendications précédentes, comprenant en outre :

- l'obtention d'au moins un indicateur indicatif d'un état de vieillissement de la batterie associé à la durée d'observation,

dans lequel les multiples paramètres indépendants sont déterminés en outre en fonction de l'au moins un indicateur indicatif de l'état de vieillissement de la batterie.

11. Procédé mis en œuvre par ordinateur selon la revendication 10,
dans lequel l'au moins un indicateur indicatif de l'état de vieillissement comprend un premier indicateur indicatif d'une perte de matière active au niveau d'une électrode de la batterie à un début de la durée d'observation et un second indicateur indicatif d'une perte de stock de porteurs de charge mobile de la batterie à un début de la durée d'observation.

**12.** Procédé mis en œuvre par ordinateur selon l'une quelconque des revendications précédentes, dans lequel les multiples paramètres indépendants définissent une forme et une amplitude de la courbe de tension de circuit ouvert de la batterie.

**13.** Procédé mis en œuvre par ordinateur selon l'une quelconque des revendications précédentes, dans lequel les multiples paramètres indépendants sont déterminés en fonction de l'au moins un spectre de contraintes à l'aide d'un modèle prédéterminé, le modèle prédéterminé étant paramétrisé en fonction de données d'entraînement obtenues pour une batterie de référence du même type de batterie que la batterie.

**14.** Procédé mis en œuvre par ordinateur selon l'une quelconque des revendications précédentes, comprenant en outre :

- la détermination de l'estimation de l'état de la batterie en fonction de la courbe de tension de circuit ouvert.

**15.** Procédé mis en œuvre par ordinateur selon l'une quelconque des revendications précédentes, comprenant en outre :

- dans une mesure de laboratoire, la détermination d'au moins un d'au moins une partie de la paramétrisation de la courbe de tension de circuit ouvert de la batterie par rapport aux multiples paramètres indépendants ou d'un modèle pour déterminer les valeurs des multiples paramètres indépendants en fonction de l'au moins un spectre de contraintes.

## FIG. 1

# FIG. 2

# FIG. 3

FIG. 4

| | |
|---|---|
| Parameterization | 3105 |

| | |
|---|---|
| Use | 3110 |

# FIG. 5

3110

```
┌ ─ ─ ─ ─ ─ ─ ─ ─ ─ ─ ─ ─ ─ ─ ─ ─ ─ ┐
│        Obtain ageing state        │─ 3005
└ ─ ─ ─ ─ ─ ─ ─ ─ ─ ─ ─ ─ ─ ─ ─ ─ ─ ┘
                  │
                  ▼
┌───────────────────────────────────┐
│        Obtain stress spectrum     │─ 3010
└───────────────────────────────────┘
                  │
                  ▼
┌───────────────────────────────────┐
│ Determine OCV-SOC curve parameter values │─ 3020
└───────────────────────────────────┘
                  │
                  ▼
┌───────────────────────────────────┐
│      Determine OCV-SOC curve      │─ 3025
└───────────────────────────────────┘
                  │
                  ▼
┌ ─ ─ ─ ─ ─ ─ ─ ─ ─ ─ ─ ─ ─ ─ ─ ─ ─ ┐
│      Determine state estimate     │─ 3030
└ ─ ─ ─ ─ ─ ─ ─ ─ ─ ─ ─ ─ ─ ─ ─ ─ ─ ┘
```

## FIG. 6

**FIG. 7**

FIG. 8

**EP 4 249 929 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2017146609 A
- US 2013317771 A
- US 2017363690 A

**Non-patent literature cited in the description**

- **TONG, S. ; KLEIN, M. P. ; PARK, J. W.** On-line optimization of battery open circuit voltage for improved state-of-charge and state-of-health estimation. *Journal of Power Sources,* 2015, vol. 293, 416-428, https://doi.org/10.1016/j.jpowsour.2015.03.157
- **CHENG, M. W. ; LEE, Y. S. ; LIU, M. ; SUN, C. C.** State-of-charge estimation with aging effect and correction for lithium-ion battery. *IET Electrical Systems in Transportation,* 2015, vol. 5 (2), 70-76, https://doi.org/10.1049/iet-est.2013.0007
- **KLINTBERG, A. ; ZOU, C. ; FRIDHOLM, B. ; WIK, T.** Kalman filter for adaptive learning of two-dimensional look-up tables applied to OCV curves for aged battery cells. *Control Engineering Practice,* 2019, vol. 84, 230-237, https://doi.org/10.1016/j.conengprac.2018.11.023
- **BIRKL, CHRISTOPH R. et al.** Degradation diagnostics for lithium ion cells. *Journal of Power Sources,* 2017, vol. 341, 373-386